(19) Europäisches Patentamt / European Patent Office / Office européen des brevets

(11) **EP 4 150 765 B1**

(12) **FASCICULE DE BREVET EUROPEEN**

(45) Date de publication et mention
de la délivrance du brevet:
**08.07.2026 Bulletin 2026/28**

(21) Numéro de dépôt: **21722258.7**

(22) Date de dépôt: **04.05.2021**

(51) Classification Internationale des Brevets (IPC):
**G01S 7/52** *(2006.01)* **H03K 19/003** *(2006.01)*

(52) Classification Coopérative des Brevets (CPC):
**H03K 19/00346; G01S 7/52023; H03K 19/018585**

(86) Numéro de dépôt international:
**PCT/EP2021/061706**

(87) Numéro de publication internationale:
**WO 2021/228626 (18.11.2021 Gazette 2021/46)**

(54) **CIRCUIT DE CONTROLE D'UN TRANSDUCTEUR ULTRASONORE**

STEUERSCHALTUNG FÜR EIN ULTRASCHALL-MESSGERÄT

ULTRASOUND TRANSDUCER CONTROL CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.05.2020 FR 2004714**

(43) Date de publication de la demande:
**22.03.2023 Bulletin 2023/12**

(73) Titulaire: **Moduleus**
**37100 Tours (FR)**

(72) Inventeur: **CHATAIN, Pascal**
**37100 TOURS (FR)**

(74) Mandataire: **Cabinet Beaumont**
**4, Place Robert Schuman**
**B.P. 1529**
**38025 Grenoble Cedex 1 (FR)**

(56) Documents cités:
**WO-A2-97/01768** **FR-A1- 2 874 704**
**US-A1- 2004 002 435**

## Description

La présente demande de brevet revendique la priorité de la demande de brevet français FR20/04714.

### Domaine technique

La présente demande concerne le domaine de l'imagerie ultrasonore, et vise plus particulièrement un circuit électronique de contrôle d'un transducteur ultrasonore d'un dispositif d'imagerie ultrasonore.

### Technique antérieure

Un dispositif d'imagerie ultrasonore comprend classiquement une pluralité de transducteurs ultrasonores, par exemple disposés en barrette ou en matrice comme décrit par exemple dans le document WO 97/01768 A2. En fonctionnement, l'ensemble des transducteurs est disposé en vis-à-vis d'un corps dont on souhaite acquérir une image. Le dispositif comprend en outre un circuit électronique de contrôle adapté à appliquer des signaux électriques d'excitation aux transducteurs, de façon à provoquer l'émission d'ondes ultrasonores par les transducteurs, en direction du corps à analyser. Les ondes ultrasonores émises par les transducteurs sont réfléchies par le corps à analyser (par sa structure interne et/ou superficielle), puis reviennent vers les transducteurs qui les convertissent à nouveau en signaux électriques. Ces signaux électriques de réponse sont lus par le circuit électronique de contrôle, et peuvent être mémorisés et analysés pour en déduire des informations sur le corps étudié.

Il serait souhaitable d'améliorer au moins en partie certains aspects des circuits connus de contrôle de transducteurs ultrasonores.

### Résumé de l'invention

L'invention est défini par les caractéristiques de la revendication 1 et prévoit un circuit de contrôle d'un transducteur ultrasonore, comportant un circuit de réception ayant une borne d'entrée destinée à être reliée à une électrode du transducteur, ledit circuit de réception comportant un circuit analogique de compression de dynamique.

Selon un mode de réalisation, le circuit de réception comprend en outre un convertisseur analogique-numérique, le circuit analogique de compression de dynamique ayant un noeud d'entrée relié à la borne d'entrée du circuit de réception et un noeud de sortie relié à un noeud d'entrée du convertisseur analogique-numérique.

Selon un mode de réalisation, le circuit comporte en outre, en sortie du convertisseur analogique-numérique, un circuit de correction numérique configuré pour appliquer au signal de sortie du convertisseur analogique-numérique un gain numérique variable en fonction de l'amplitude du signal, compensant la variation de gain analogique appliquée par le circuit analogique de compression de dynamique.

Selon l'invention, le circuit analogique de compression de dynamique est un circuit d'amplification non linéaire ayant une fonction de transfert symétrique, ladite fonction de transfert étant, pour des signaux d'entrée positifs, une fonction monotone croissante dont la dérivée décroit de façon monotone en fonction de l'amplitude du signal d'entrée.

Selon un mode de réalisation, le circuit de compression de dynamique présente une fonction de transfert de type arc sinus hyperbolique, arc tangente, log ou sinus.

Selon un mode de réalisation, le circuit de compression de dynamique comprend une pluralité d'amplificateurs analogiques et un sommateur de tensions analogiques.

Selon un mode de réalisation, les amplificateurs analogiques sont reliés en série, chaque amplificateur analogique ayant un noeud de sortie relié à un noeud d'entrée correspondant du sommateur de tension.

Selon un mode de réalisation, chaque amplificateur analogique a son noeud de sortie relié au noeud d'entrée correspondant du sommateur de tension par l'intermédiaire d'un interrupteur.

Selon un mode de réalisation, les amplificateurs analogiques sont des amplificateurs linéaires et ont tous sensiblement le même gain.

Selon un mode de réalisation, les amplificateurs analogiques sont connectés par leurs nœuds d'entrée respectifs, chaque amplificateur analogique ayant un noeud de sortie relié à un noeud d'entrée correspondant du sommateur de tension.

Selon un mode de réalisation, chaque amplificateur analogique a son noeud de sortie relié au noeud d'entrée correspondant du sommateur de tension par l'intermédiaire d'un interrupteur.

Selon un mode de réalisation, les amplificateurs analogiques sont des amplificateurs linéaires et ont tous des gains différents.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 illustre de façon schématique, sous forme de blocs, un exemple d'un circuit de commande d'un dispositif d'imagerie ultrasonore ;
la figure 2 illustre de façon schématique et partielle, sous forme de blocs, un exemple d'un circuit de commande d'un transducteur ultrasonore selon un mode de réalisation ;
la figure 3 est un diagramme illustrant un exemple de fonction de transfert d'un circuit de compression de dynamique du circuit de commande de la figure 2 ;
la figure 4 est un diagramme illustrant un autre exemple de fonction de transfert d'un circuit de compression de dynamique du circuit de commande de la figure 2 ;
la figure 5 illustre de façon schématique, sous forme de bloc, un exemple de réalisation d'un circuit de compression de dynamique du circuit de commande de la figure 2 ; et
la figure 6 illustre de façon schématique, sous forme de bloc, un autre exemple de réalisation d'un circuit de compression de dynamique du circuit de commande de la figure 2.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

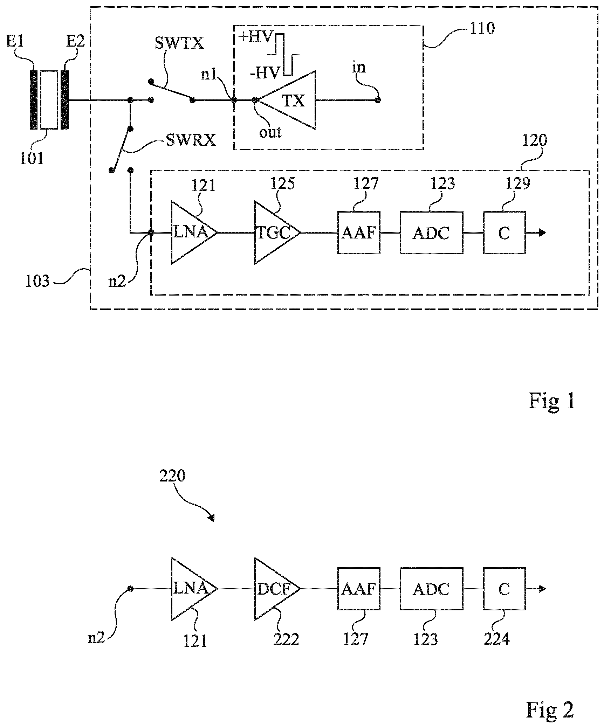

La figure 1 est un schéma électrique simplifié d'un exemple d'un dispositif d'imagerie ultrasonore 100.

Le dispositif 100 comprend au moins un transducteur ultrasonore 101, par exemple un transducteur de type CMUT (transducteur ultrasonore capacitif à membrane). A titre de variante, le transducteur 101 peut être un transducteur électro-capacitif, un transducteur piézoélectrique, un transducteur à cristal, ou tout autre type de transducteur ultrasonore. Le transducteur 101 comprend deux électrodes E1 et E2. Lorsqu'une tension d'excitation appropriée est appliquée entre les électrodes E1 et E2, le transducteur émet une onde acoustique ultrasonore. Lorsque le transducteur reçoit une onde acoustique ultrasonore dans une certaine gamme de fréquence, il fournit entre ses électrodes E1 et E2 une tension représentative de l'onde reçue.

Le dispositif 100 comprend en outre un circuit électronique 103 de commande du transducteur 101. Le circuit de commande 103 comprend un circuit d'émission 110, adapté à appliquer un signal électrique d'excitation au transducteur 101 pendant une phase d'émission d'une onde ultrasonore, et un circuit de réception 120 adapté à amplifier et numériser un signal électrique de réponse généré par le transducteur 101 pendant une phase de réception d'une onde ultrasonore (et plus généralement à conditionner les signaux électriques générés par le transducteur 101 pendant la phase de réception).

Le circuit d'émission 110 comprend une borne de sortie n1 destinée à être reliée, par exemple connectée, à l'électrode E2 du transducteur 101. Dans cet exemple, le circuit d'émission 110 comprend un générateur d'impulsions TX ayant un noeud d'entrée in destiné à recevoir un signal logique de commande, et un noeud de sortie out relié, par exemple connecté, à la borne n1. Le noeud d'entrée in du générateur d'impulsions TX peut être relié, par exemple connecté, à un noeud de sortie d'un circuit logique de contrôle, non représenté, du dispositif. Lorsque le signal logique appliqué sur le noeud d'entrée in du générateur TX est à un premier état, le générateur TX fournit sur son noeud de sortie out une tension de niveau haut +HV, et, lorsque le signal logique appliqué sur le noeud in du générateur TX est à un deuxième état, le générateur TX fournit sur son noeud de sortie out une tension de niveau bas -HV. Le signal de sortie du générateur d'impulsions TX correspond à un signal d'excitation du transducteur 101, qui peut être appliqué sur l'électrode E2 du transducteur. Le niveau de tension de ce signal d'excitation peut être relativement élevé, par exemple de l'ordre de 10 à 100 volts crête à crête.

Le circuit de réception 120 comprend une borne d'entrée n2 destinée à être reliée, par exemple connectée, à l'électrode E2 du transducteur 101. Dans cet exemple, le circuit de réception 120 comprend un amplificateur de réception 121, de préférence à faible bruit (LNA), ayant un noeud d'entrée relié, par exemple connecté, à la borne n2. De plus, dans cet exemple, le circuit de réception 120 comprend un convertisseur analogique numérique 123 (ADC) ayant un noeud d'entrée relié à un noeud de sortie de l'amplificateur 121. Le convertisseur 123 est adapté à fournir des échantillons numériques quantifiés sur plusieurs bits, par exemple sur 8 à 16 bits, représentatifs de l'amplitude du signal d'entrée du convertisseur. Dans l'exemple de la figure 1, le circuit de réception 120 comprend en outre, entre la sortie de l'amplificateur 121 et l'entrée du convertisseur analogique-numérique 123, un circuit 125 d'ajustement temporel de gain (TGC). Le circuit 125 est commandable pour appliquer un gain analogique variable en fonction du temps au signal de sortie de l'amplificateur 121, au cours d'une phase de réception d'un signal retour reçu par le transducteur 101. Plus particulièrement, lors d'une phase de réception d'une onde ultrasonore retour par le transducteur 101, le gain appliqué par le circuit 125 au signal de sortie de l'amplificateur 121 augmente progressivement en fonction du temps, et donc en fonction de la profondeur de la zone explorée, de façon à compenser l'atténuation du signal ultrasonore par le milieu exploré. Ceci permet d'exploiter au mieux la dynamique du convertisseur analogique-numérique 123 pendant toute la durée de la phase de réception, et ainsi de limiter le bruit de quantification introduit par le convertisseur analogique-numérique 123, notamment pour les échos ultrasonores les plus lointains. Dans l'exemple de la figure 1, le circuit de réception 120 comprend en outre un filtre analogique anti-repliement 127 (AAF), par exemple un filtre passe bas, disposé entre la sortie de l'amplificateur 121 et l'entrée du convertisseur analogique numérique 123. Le filtre anti-repliement 127 est par exemple disposé entre la sortie du circuit d'ajustement temporel de gain 125 et l'entrée du convertisseur 123. Le circuit de réception 120 de la figure 1 comprend de plus, en sortie du convertisseur analogique-numérique 123, un circuit numérique de correction 129 (C), adapté à appliquer au signal de sortie du convertisseur 123 un gain numérique variable en fonction du temps, visant à compenser la variation temporelle de gain analogique appliquée par le circuit 125 en amont du convertisseur 123. Le signal numérique de sortie du circuit de correction 129 peut par exemple être transmis à un circuit numérique de traitement, non représenté.

Dans l'exemple représenté, le circuit de commande 103 comprend un interrupteur d'émission SWTX ayant un premier noeud de conduction relié, par exemple connecté, à la borne de sortie n1 du circuit d'émission 110, et un deuxième noeud de conduction relié, par exemple connecté, à l'électrode E2 du transducteur 101. De plus, dans cet exemple, le circuit de commande 103 comprend un interrupteur de réception SWRX ayant un premier noeud de conduction relié, par exemple connecté, à la borne d'entrée n2 du circuit de réception 120, et un deuxième noeud de conduction relié, par exemple connecté, à l'électrode E2 du transducteur 101. Les interrupteurs SWTX et SWRX peuvent être maintenus respectivement fermé et ouvert pendant les phases d'émission, et respectivement ouvert et fermé pendant les phases de réception. A titre de variante, l'interrupteur SWTX peut être omis, la borne de sortie n1 du circuit d'émission 110 étant alors directement connectée à l'électrode E2 du transducteur 101. Par ailleurs, à titre de variante, l'interrupteur SWRX peut être omis, la borne d'entrée n2 du circuit de réception 120 étant alors directement connectée à l'électrode E2 du transducteur 101. Dans ce dernier cas, un circuit d'écrêtage, non représenté, peut être prévu entre la borne n2 et un noeud d'application d'un potentiel de référence du circuit, par exemple la masse, de façon à protéger le circuit de réception 120 pendant les phases d'émission, et notamment à éviter la destruction de l'amplificateur d'entrée 121 du circuit de réception 120 sous l'effet du signal électrique d'excitation appliqué par le générateur d'impulsions TX.

Pendant les phases d'émission et/ou de réception, l'électrode E1 du transducteur 101 peut être maintenue à un potentiel de référence du dispositif, par exemple la masse.

Bien qu'un unique transducteur 101 ait été représenté sur la figure 1, en pratique, le dispositif 100 peut comporter un grand nombre de transducteurs, par exemple identiques ou similaires. Dans ce cas, le circuit électronique de contrôle 103 peut comporter un circuit d'émission 110 et un circuit de réception 120 dédiés par transducteur ultrasonore 101. A titre de variante, un même circuit d'émission 110 et/ou un même circuit de réception 120 peuvent être partagés par plusieurs transducteurs ultrasonores 101.

Une limitation du circuit électronique de contrôle 103 décrit en relation avec la figure 1 réside dans la difficulté de réalisation et de pilotage du circuit d'ajustement de gain temporel 125.

La figure 2 illustre de façon schématique et partielle, sous forme de blocs, un exemple d'un circuit de commande d'un transducteur ultrasonore selon un mode de réalisation. Le circuit de commande de la figure 2 diffère du circuit de commande 103 décrit précédemment en relation avec la figure 1 principalement par la réalisation de son circuit de réception 220. Ainsi, par souci de simplification, seul le circuit de réception 220, remplaçant le circuit de réception 120 de la figure 1, a été représenté sur la figure 2.

Le circuit de réception 220 de la figure 2 présente des éléments communs avec le circuit de réception 120 de la figure 1. Dans la suite de la description, ces éléments communs ne seront pas détaillés à nouveau, et seules les différences par rapport au circuit de réception 120 de la figure 1 seront mises en exergue.

Comme le circuit 120 de la figure 1, le circuit de réception 220 de la figure 2 comprend une borne d'entrée n2 et un amplificateur de réception 121, de préférence à faible bruit (LNA), ayant un noeud d'entrée relié, par exemple connecté, à la borne n2. De plus, comme dans l'exemple de la figure 1, le circuit de réception 220 de la figure 2 comprend un convertisseur analogique numérique 123 (ADC) ayant un noeud d'entrée relié à un noeud de sortie de l'amplificateur 121.

Le circuit de réception 220 de la figure 2 diffère du circuit de réception 120 de la figure 1 principalement en ce qu'il ne comprend pas le circuit d'ajustement temporel de gain analogique 125 (TGC) du circuit 120.

Dans le mode de réalisation de la figure 2, le circuit de réception 220 comprend en revanche, entre la borne d'entrée n2 et l'entrée du convertisseur analogique-numérique 123, un circuit analogique de compression de dynamique 222 (DCF). Dans l'exemple représenté, le circuit 222 a un noeud d'entrée relié, par exemple connecté, au noeud de sortie de l'amplificateur 121, et un noeud de sortie relié au noeud d'entrée du convertisseur analogique-numérique 123.

A la différence du circuit 125 de la figure 1 qui présente une fonction de transfert linéaire variable en fonction du temps, le circuit 222 présente une fonction de transfert non linéaire.

Plus particulièrement, par circuit de compression de dynamique, on entend ici que le circuit 222 présente, pour des signaux d'entrée positifs, une fonction de transfert monotone croissante dont la dérivée (c'est-à-dire le coefficient directeur de la tangente à la courbe) décroit de façon monotone en fonction de l'amplitude du signal d'entrée, sur toute l'étendue de la gamme de dynamique d'entrée du circuit (i.e. jusqu'au seuil de saturation du circuit). La fonction de transfert du circuit 222 est de plus symétrique. Ainsi, le circuit 222 amplifie plus fortement les signaux présentant une amplitude relativement faible (en valeur absolue) et plus faiblement les signaux présentant une amplitude relativement élevée (en valeur absolue).

Dans l'exemple de la figure 2, le circuit de réception 220 comprend en outre un filtre analogique anti-repliement 127 (AAF), par exemple un filtre passe bas, disposé entre la sortie de l'amplificateur 121 et l'entrée du convertisseur analogique numérique 123. Le filtre anti-repliement 127 est par exemple disposé entre la sortie du circuit de compression de dynamique 222 et l'entrée du convertisseur 123.

Le circuit de réception 220 de la figure 2 comprend de plus, en sortie du convertisseur analogique-numérique 123, un circuit numérique de correction 224 (C), adapté à appliquer au signal de sortie du convertisseur 123 un gain numérique variable en fonction de l'amplitude du signal, compensant la variation de gain analogique appliquée par le circuit 222 en amont du convertisseur 123. Le signal numérique de sortie du circuit de correction 224 peut par exemple être transmis à un circuit numérique de traitement, non représenté.

Dans le circuit de réception 220 de la figure 2, le circuit de compression de dynamique 222 permet d'amplifier plus fortement les signaux de faible amplitude, c'est-à-dire non seulement les échos les plus lointains comme le faisait déjà le circuit d'ajustement temporel de gain 125 de la figure 1, mais également les échos faibles provenant d'objets proches du transducteur, ce que ne permettait pas de faire le circuit d'ajustement temporel 125 de la figure 1. Ceci permet de limiter le bruit de quantification introduit par le convertisseur analogique-numérique 123 pour tous les signaux de faible amplitude. Pour les signaux de plus forte amplitude, l'amplification est plus faible ce qui revient à augmenter le bruit de quantification introduit par le convertisseur analogique-numérique 123, comme cela était déjà effectué pour les échos proches avec le circuit d'ajustement temporel de gain 125 de la figure 1.

Le circuit de réception 220 de la figure 2 permet en outre avantageusement de se passer d'un circuit d'ajustement temporel de gain, relativement complexe à réaliser et à contrôler.

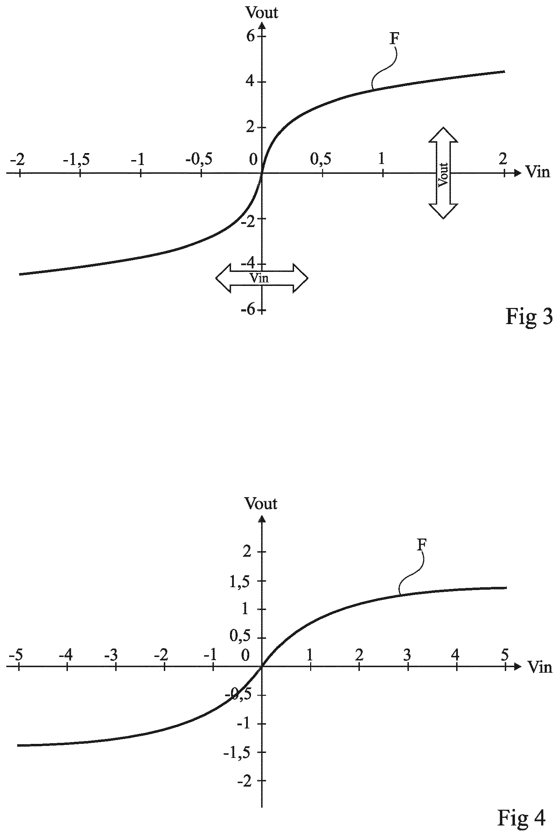

Des exemples de fonctions de transfert pouvant être mises en oeuvre par le circuit 222 vont être décrits ci-après en relation avec les figures 3 et 4. La réalisation de circuits 222 présentant de telles fonctions de transfert, ou, plus généralement, toute autre fonction de transfert adaptée à mettre en oeuvre la fonction de compression de dynamique recherchée, n'a pas été détaillée, la réalisation de telles fonctions d'amplification non linéaires étant à la portée de la personne du métier en utilisant des composants électroniques connus, notamment des composants à base de silicium, par exemple des transistors.

On notera par ailleurs que la fonction d'amplification non linéaire recherchée peut être mise en oeuvre en tout ou partie par le circuit d'amplification d'entrée 121. Ainsi, dans une variante de réalisation non représentée sur la figure 2, le circuit 121 peut être intégré au circuit 222, l'entrée du circuit 222 étant alors directement reliée, par exemple connectée, à la borne d'entrée n2 du circuit de réception 220.

La figure 3 est un diagramme illustrant un premier exemple de fonction de transfert pouvant être mise en oeuvre par le circuit de compression de dynamique 222 de la figure 2. Sur la figure 3, on a représenté, sur l'axe des abscisses, un signal Vin correspondant à la tension d'entrée appliquée sur le noeud d'entrée du circuit 222, et, sur l'axe des ordonnées, un signal Vout correspondant à la tension de sortie du circuit 222.

Dans cet exemple, la fonction de transfert F du circuit 222 est une fonction arc sinus hyperbolique (ASINH).

On notera que la fonction arc sinus hyperbolique est une fonction logarithmique pouvant s'exprimer comme suit :

[Math 1]

$$ASINH(x) = \log\left(x + \sqrt{x^2 - 1}\right)$$

Une telle fonction peut aisément être mise en oeuvre par des composants semiconducteurs non linéaires, par exemple des composants à base de silicium, par exemple des transistors.

La figure 4 est un diagramme illustrant un deuxième exemple de fonction de transfert pouvant être mise en oeuvre par le circuit de compression de dynamique 222 de la figure 2. Comme sur la figure 3, on a représenté sur la figure 4, sur l'axe des abscisses, un signal Vin correspondant à la tension d'entrée appliquée sur le noeud d'entrée du circuit 222, et, sur l'axe des ordonnées, un signal Vout correspondant à la tension de sortie du circuit 222.

Dans cet exemple, la fonction de transfert F du circuit 222 est une fonction arc tangente (ATAN), qui présente elle aussi l'avantage de pouvoir être implémentée relativement aisément à partir de composants électroniques existants, par exemple des composants semiconducteurs à base de silicium, par exemple des transistors.

Plus généralement, toute autre fonction de compression de dynamique peut être utilisée, par exemple une fonction logarithmique, une fonction sinus entre $-\pi/2$ et $+\pi/2$, etc.

La fonction de correction numérique appliquée par le circuit 224 en aval du convertisseur analogique-numérique 123 peut être choisie de façon à obtenir, in fine, une représentation linéaire du signal acoustique reçu par le transducteur. A titre d'exemple, si F désigne la fonction de transfert appliquée par le circuit analogique de compression de dynamique 222, la fonction de compensation appliquée par le circuit de correction numérique 224 peut être une fonction du type $x = F^{-1}(y)$. La correction appliquée par le circuit 224 peut être une fonction déterminée mathématiquement et implémentée par un circuit de traitement numérique, par exemple de type microprocesseur, circuit logique programmable, etc. Toutefois, de façon préférentielle, la correction mise en oeuvre par le circuit 224 est implémentée au moyen d'une table de correspondance déterminée au préalable lors d'une phase de calibration du dispositif. Ceci permet avantageusement de corriger l'ensemble des distorsions éventuelles liées aux différents composants du circuit de réception 220.

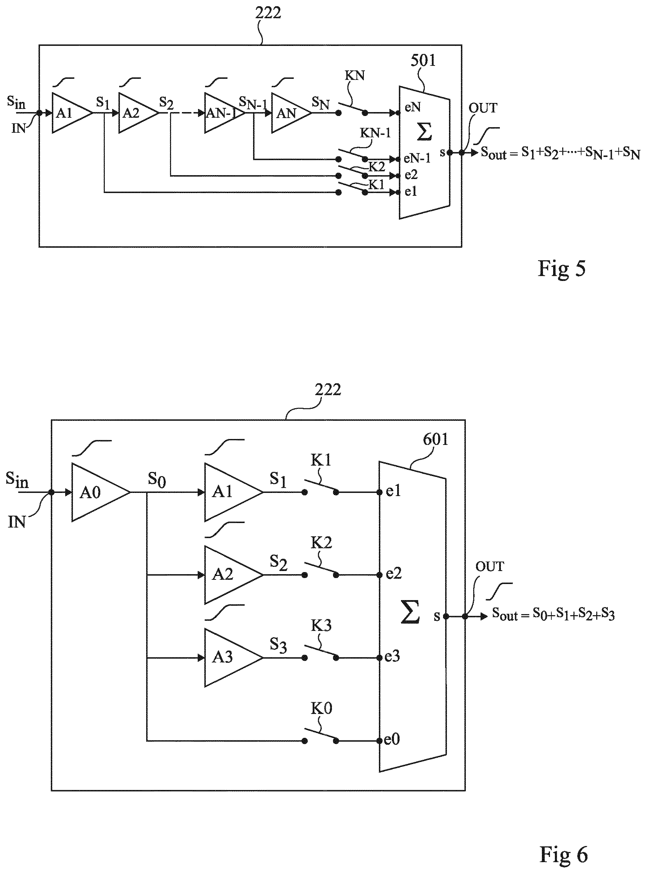

La figure 5 illustre de façon schématique, sous forme de blocs, un exemple de réalisation du circuit de compression de dynamique 222 du circuit de réception 220 de la figure 2.

Dans cet exemple, la fonction de compression de dynamique est implémentée au moyen d'une pluralité d'amplificateurs analogiques à réponse linéaire reliés en série, et d'un sommateur de tensions analogiques.

Plus particulièrement, dans l'exemple représenté, le circuit 222 comprend N amplificateurs linéaires A1, ... AN, avec N entier supérieur ou égal à 2, et un sommateur de tensions 501 à N entrées e1, ... eN.

Chaque amplificateur Ai, avec i entier allant de 1 à N, à l'exception de l'amplificateur A1, a son noeud d'entrée relié, par exemple connecté, au noeud de sortie de l'amplificateur de rang précédent Ai-1. L'amplificateur A1 a son noeud d'entrée relié, par exemple connecté, au noeud d'entrée du circuit 222, désigné par la référence IN sur la figure 5.

Les amplificateurs A1, ... AN ont par ailleurs leurs noeuds de sortie respectifs reliés respectivement aux noeuds d'entrée e1, ... eN du sommateur 501. Dans l'exemple représenté, les nœuds de sortie des amplificateurs A1, ... AN sont reliés aux nœuds d'entrée e1, ... eN du sommateur par respectivement N interrupteurs K1, ... KN. Plus particulièrement, dans cet exemple, chaque interrupteur Ki a un premier noeud de conduction relié, par exemple connecté, au noeud de sortie de l'amplificateur Ai de même rang i, et un deuxième noeud de conduction relié, par exemple connecté, au noeud d'entrée ei de même rang i du sommateur de tensions 501. A titre de variante, les interrupteurs K1, ... KN peuvent être omis, auquel cas chaque amplificateur Ai a son noeud de sortie directement relié, par exemple connecté, au noeud d'entrée ei de même rang i du sommateur 501.

En fonctionnement, le circuit 222 reçoit sur son noeud d'entrée IN un signal $S_{in}$ correspondant par exemple au signal de sortie de l'amplificateur 121 de la figure 2. A titre de variante, l'amplificateur 121 de la figure 2 peut correspondre à l'amplificateur A1 du circuit 222 de la figure 5, auquel cas le signal d'entrée $S_{in}$ correspond au signal reçu sur la borne d'entrée n2 du circuit de réception 220 de la figure 2.

Le sommateur 501 fournit, sur un noeud de sortie s, un signal $S_{out}$ égal à la somme des tensions $S_1$, ... $S_N$ appliquées sur ses nœuds d'entrée $e_1$, ... $e_N$.

Chaque amplificateur Ai applique un gain sensiblement fixe dans toute l'étendue de sa gamme de dynamique, jusqu'à son seuil de saturation. Le gain appliqué est par exemple le même pour les N amplificateurs A1, ... AN, par exemple un gain de l'ordre de 20 dB.

En considérant tous les interrupteurs K1, ... KN fermés, pour des signaux d'entrée $S_{in}$ de faible amplitude, les N amplificateurs A1, ... AN participent à l'amplification du signal. La contribution du signal de sortie $S_N$ de l'amplificateur AN au signal $S_{out}$ est alors prépondérante devant les contributions des signaux $S_1$, ... $S_{N-1}$. Lorsque le seuil de saturation de l'amplificateur AN est atteint, le signal $S_N$ n'évolue plus et reste bloqué à sa valeur maximale ou valeur de saturation. Une amplification linéaire reste assurée par les amplificateurs A1, ... $A_{N-1}$. La contribution du signal $S_{N-1}$ au signal de sortie $S_{out}$ devient en particulier significative, et prépondérante devant les contributions des signaux $S_1$, ... $S_{N-2}$. Pour des signaux d'entrée $S_{in}$ d'amplitude élevée, lorsque le seuil de saturation de l'amplificateur A2 est atteint, seul l'amplificateur A1 continue d'amplifier linéairement le signal.

On obtient ainsi une fonction de transfert $S_{out}=F(S_{in})$ non linéaire, assurant la fonction de compression de dynamique recherchée.

Comme dans les exemples précédents, la fonction de correction numérique appliquée par le circuit 224 en aval du convertisseur analogique-numérique 123 peut être déterminée mathématiquement et implémentée par un circuit de traitement numérique par exemple de type microprocesseur, circuit logique programmable, etc. Toutefois, de façon préférentielle, la correction mise en oeuvre par le circuit 224 est implémentée au moyen d'une table de correspondance déterminée au préalable lors d'une phase de calibration du dispositif.

A titre de variante, dans le cas illustré par la figure 5 dans lequel les nœuds de sortie des amplificateurs A1, ... AN sont reliés aux nœuds d'entrée e1, ... eN du sommateur par respectivement N interrupteurs K1, ... KN, on peut en outre prévoir de mettre en oeuvre une fonction d'ajustement temporel discret de la fonction de transfert du circuit 222. En particulier, on pourra prévoir, pendant une phase de réception d'une onde ultrasonore, de fermer successivement les interrupteurs K1 à KN au cours de la phase de réception, de façon à augmenter par paliers successifs le gain maximum disponible en fonction de la profondeur explorée. On notera que par rapport à un ajustement temporel continu du type mis en oeuvre par le circuit 125 de la figure 1, cette fonction d'ajustement discret (par paliers) est relativement simple à mettre en oeuvre.

La figure 6 illustre de façon schématique, sous forme de blocs, un autre exemple de réalisation du circuit de compression de dynamique 222 du circuit de réception 220 de la figure 2.

Là encore, la fonction de compression de dynamique est implémentée au moyen d'une pluralité d'amplificateurs analogiques à réponse linéaire, et d'un sommateur de tensions analogiques.

Plus particulièrement, dans cet exemple, le circuit 222 comprend N+1 amplificateurs linéaires A0, A1, ... AN, avec N entier supérieur ou égal à 2, et un sommateur de tensions 601 à N+1 entrées e0, e1, ... eN. Dans l'exemple représenté, N est égal à 3, les modes de réalisation décrits ne se limitant bien entendu pas à ce cas particulier.

L'amplificateur A0 a son noeud d'entrée relié, par exemple connecté, au noeud d'entrée IN du circuit 122. L'amplificateur A0 correspond par exemple à l'amplificateur 121 du circuit de réception 220 de la figure 2, qui se trouve alors intégré dans le circuit de compression de dynamique 222.

Chaque amplificateur Ai, avec i entier allant de 1 à N, a son noeud d'entrée relié, par exemple connecté, au noeud de sortie de l'amplificateur A0. Les amplificateurs A1, ... AN ont par ailleurs leurs noeuds de sortie respectifs reliés respectivement aux noeuds d'entrée e1, ... eN du sommateur 601. Dans l'exemple représenté, les nœuds de sortie des amplificateurs A1, ... AN sont reliés aux nœuds d'entrée e1, ... eN du sommateur par respectivement N interrupteurs K1, ... KN. Plus particulièrement, dans cet exemple, chaque interrupteur Ki a un premier noeud de conduction relié, par exemple connecté, au noeud de sortie de l'amplificateur Ai de même rang i, et un deuxième noeud de conduction relié, par exemple connecté, au noeud d'entrée ei de même rang i du sommateur de tensions 601. A titre de variante, les interrupteurs K1, ... KN peuvent être omis, auquel cas chaque amplificateur Ai a son noeud de sortie directement relié, par exemple connecté, au noeud d'entrée ei de même rang i du sommateur 601. Par ailleurs, dans cet exemple, l'amplificateur A0 a son noeud de sortie relié au noeud d'entrée e0 du sommateur 601 par l'intermédiaire d'un interrupteur K0. A titre de variante, l'interrupteur K0 peut être omis, auquel cas le noeud de sortie de l'amplificateur A0 peut être directement relié, par exemple connecté, au noeud d'entrée e0 du sommateur 601.

En fonctionnement, le circuit 222 reçoit sur son noeud d'entrée IN un signal $S_{in}$.

Le sommateur 601 fournit, sur un noeud de sortie s, un signal $S_{out}$ égal à la somme des tensions $S_1$, ... $S_N$ appliquées sur ses nœuds d'entrée $e_1$, ... $e_N$.

Dans l'exemple de la figure 6, chaque amplificateur Ai, avec i entier allant de 1 à N, présente un gain strictement supérieur à celui de l'amplificateur de rang précédent Ai-1.

En considérant tous les interrupteurs K0, K1, ... KN fermés, pour des signaux d'entrée $S_{in}$ de faible amplitude, les N amplificateurs A0, A1, ... AN participent à l'amplification du signal. La contribution du signal de sortie $S_N$ de l'amplificateur AN au signal $S_{out}$ est toutefois prépondérante devant les contributions des signaux $S_0$, $S_1$, ... $S_{N-1}$. Lorsque le seuil de saturation de l'amplificateur AN est atteint, le signal $S_N$ n'évolue plus et reste bloqué à sa valeur maximale ou valeur de saturation. Une amplification linéaire reste assurée par les amplificateurs A0, A1, ... $A_{N-1}$. La contribution du signal $S_{N-1}$ au signal de sortie $S_{out}$ devient en particulier significative, et prépondérante devant les contributions des signaux $S_0$, ... $S_{N-2}$. Pour des signaux d'entrée $S_{in}$ d'amplitude élevée, lorsque le seuil de saturation de l'amplificateur A1 est atteint, seul l'amplificateur A0 continue d'amplifier linéairement le signal.

On obtient ainsi une fonction de transfert $S_{out}=F(S_{in})$ non linéaire, assurant la fonction de compression de dynamique recherchée.

Comme dans les exemples précédents, la fonction de correction numérique appliquée par le circuit 224 en aval du convertisseur analogique-numérique 123 peut être déterminée mathématiquement et implémentée par un circuit de traitement numérique par exemple de type microprocesseur, circuit logique programmable, etc. Toutefois, de façon préférentielle, la correction mise en oeuvre par le circuit 224 est implémentée au moyen d'une table de correspondance déterminée au préalable lors d'une phase de calibration du dispositif.

A titre de variante, dans le cas illustré par la figure 6 dans lequel les nœuds de sortie des amplificateurs A0, A1, ... AN sont reliés aux nœuds d'entrée a0, e1, ... eN du sommateur par respectivement N+1 interrupteurs K0, K1, ... KN, on peut en outre prévoir de mettre en oeuvre une fonction d'ajustement temporel discret de la fonction de transfert du circuit 222. En particulier, on pourra prévoir, pendant une phase de réception d'une onde ultrasonore, de fermer successivement les interrupteurs K0 à KN au cours de la phase de réception, de façon à augmenter par paliers successifs le gain maximum disponible en fonction de la profondeur explorée.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples décrits ci-dessus de réalisation du circuit de compression de dynamique 222 du circuit de réception 220.

## Revendications

1. Circuit (103) de contrôle d'un transducteur ultrasonore (101), comportant un circuit de réception (220) ayant une borne d'entrée (n2) destinée à être reliée à une électrode (E2) du transducteur, ledit circuit de réception (220) comportant un circuit analogique de compression de dynamique (222), dans lequel le circuit analogique de compression de dynamique (222) est un circuit d'amplification non linéaire ayant une fonction de transfert symétrique, ladite fonction de transfert étant, pour des signaux d'entrée positifs, une fonction monotone croissante dont la dérivée décroît de façon monotone en fonction de l'amplitude du signal d'entrée, de sorte que le circuit de compression de dynamique (222) amplifie plus fortement les signaux présentant une amplitude relativement faible en valeur absolue et plus faiblement les signaux présentant une amplitude relativement élevée en valeur absolue.

**2.** Circuit (103) selon la revendication 1, dans lequel le circuit de réception (220) comprend en outre un convertisseur analogique-numérique (123), le circuit analogique de compression de dynamique ayant un noeud d'entrée relié à la borne d'entrée du circuit de réception (220) et un noeud de sortie relié à un noeud d'entrée du convertisseur analogique-numérique.

**3.** Circuit (103) selon la revendication 2, comportant en outre, en sortie du convertisseur analogique-numérique (123), un circuit de correction numérique (224) configuré pour appliquer au signal de sortie du convertisseur analogique-numérique (123) un gain numérique variable en fonction de l'amplitude du signal, compensant la variation de gain analogique appliquée par le circuit analogique de compression de dynamique (222).

**4.** Circuit (103) selon l'une quelconque des revendications 1 à 3, dans lequel le circuit de compression de dynamique (222) présente une fonction de transfert de type arc sinus hyperbolique, arc tangente, log ou sinus.

**5.** Circuit (103) selon l'une quelconque des revendications 1 à 3, dans lequel le circuit de compression de dynamique (222) comprend une pluralité d'amplificateurs analogiques (A1, ... AN) et un sommateur de tensions analogiques (501 ; 601).

**6.** Circuit (103) selon la revendication 5, dans lequel les amplificateurs analogiques (A1, ... AN) sont reliés en série, chaque amplificateur analogique (Ai) ayant un noeud de sortie relié à un noeud d'entrée (ei) correspondant du sommateur de tension (501).

**7.** Circuit (103) selon la revendication 6, dans lequel chaque amplificateur analogique (Ai) a son noeud de sortie relié au noeud d'entrée (ei) correspondant du sommateur de tension (501) par l'intermédiaire d'un interrupteur (Ki).

**8.** Circuit (103) selon la revendication 6 ou 7, dans lequel les amplificateurs analogiques (A1, ... AN) sont des amplificateurs linéaires et ont tous sensiblement le même gain.

**9.** Circuit (103) selon la revendication 5, dans lequel les amplificateurs analogiques (A1, ... AN) sont connectés par leurs nœuds d'entrée respectifs, chaque amplificateur analogique (Ai) ayant un noeud de sortie relié à un noeud d'entrée (ei) correspondant du sommateur de tension (601).

**10.** Circuit (103) selon la revendication 9, dans lequel chaque amplificateur analogique (Ai) a son noeud de sortie relié au noeud d'entrée (ei) correspondant du sommateur de tension (601) par l'intermédiaire d'un interrupteur (Ki).

**11.** Circuit (103) selon la revendication 10, dans lequel les amplificateurs analogiques (A1, ... AN) sont des amplificateurs linéaires et ont tous des gains différents.

**Patentansprüche**

**1.** Eine Schaltung (103) zum Steuern eines Ultraschall-Wandlers (101), das Folgendes aufweist: eine Empfangsschaltung (220) mit einem Eingangsanschluss (n2), der dazu vorgesehen ist, mit einer Elektrode (E2) des Wandlers gekoppelt zu werden, wobei die Empfangsschaltung (220) eine analoge Dynamikbereich-Kompressionsschaltung (222) aufweist, wobei die analoge Dynamikbereich-Kompressionsschaltung (222) eine nichtlineare Verstärkungsschaltung mit einer symmetrischen Übertragungsfunktion ist, wobei die Übertragungsfunktion für positive Eingangssignale eine monoton steigende Funktion ist, deren Ableitung monoton abnehmend entsprechend der Amplitude des Eingangssignals ist, so dass die analoge Dynamikbereich-Kompressionsschaltung (222) Signale mit einer im Absolutwert relativ kleinen Amplitude stärker verstärkt und Signale mit einer im Absolutwert relativ hohen Amplitude schwächer verstärkt.

**2.** Schaltung (103) nach Anspruch 1, wobei die Empfangsschaltung (220) ferner einen Analog-Digital-Wandler (123) aufweist, wobei die analoge Dynamikbereich-Kompressionsschaltung einen Eingangsknoten, der mit dem Eingangsanschluss der Empfangsschaltung (220) gekoppelt ist, und einen Ausgangsknoten aufweist, der mit einem Eingangsknoten des Analog-Digital-Wandlers gekoppelt ist.

**3.** Schaltung (103) nach Anspruch 2, ferner aufweisend, am Ausgang des Analog-Digital-Wandlers (123), eine digitale Korrekturschaltung (224), die eingerichtet ist zum Anwenden eines digitalen Verstärkungsfaktors, der entsprechend der Amplitude des Signals variiert, auf das Ausgangssignal des Analog-Digital-Wandlers (123), zum Kompensieren der durch die analoge Dynamikbereich-Kompressionsschaltung (222) angewandten analogen Verstärkungsvariation.

**4.** Schaltung (103) nach einem der Ansprüche 1 bis 3, wobei die Dynamikbereich-Kompressionsschaltung (222) eine Übertragungsfunktion vom Typ hyperbolischer Arkussinus, Arkustangens, log oder Sinus aufweist.

**5.** Schaltung (103) nach einem der Ansprüche 1 bis 3, wobei die Dynamikbereich-Kompressionsschaltung (222) eine Vielzahl von analogen Verstärkern (A1, ..., AN) und einen Addierer analoger Spannungen (501; 601) aufweist.

**6.** Schaltung (103) nach Anspruch 5, wobei die analogen Verstärker (A1, ... AN) in Reihe gekoppelt sind, wobei jeder analoge Verstärker (Ai) einen Ausgangsknoten aufweist, der mit einem entsprechenden Eingangsknoten (ei) des Spannungsaddierers (501) gekoppelt ist.

**7.** Schaltung (103) nach Anspruch 6, wobei jeder analoge Verstärker (Ai) seinen Ausgangsknoten aufweist, der mit dem entsprechenden Eingangsknoten (ei) des Spannungsaddierers (501) über einen Schalter (Ki) gekoppelt ist.

**8.** Schaltung (103) nach Anspruch 6 oder 7, wobei die analogen Verstärker (A1, ... AN) lineare Verstärker sind und alle im Wesentlichen dieselbe Verstärkung haben.

**9.** Schaltung (103) nach Anspruch 5, wobei die analogen Verstärker (A1, ... AN) durch ihre jeweiligen Eingangsknoten verbunden sind, wobei jeder analoge Verstärker (Ai) einen Ausgangsknoten aufweist, der mit einem entsprechenden Eingangsknoten (ei) des Spannungsaddierers (601) gekoppelt ist.

**10.** Schaltung (103) nach Anspruch 9, wobei jeder analoge Verstärker (Ai) seinen Ausgangsknoten aufweist, der mit dem entsprechenden Eingangsknoten (ei) des Spannungsaddierers (601) über einen Schalter (Ki) gekoppelt ist.

**11.** Schaltung (103) nach Anspruch 10, wobei die analogen Verstärker (A1, ... AN) lineare Verstärker sind und alle unterschiedliche Verstärkungen haben.

**Claims**

**1.** Circuit (103) for controlling an ultrasonic transducer (101), comprising a receive circuit (220) having an input terminal (n2) intended to be coupled to an electrode (E2) of the transducer, said receive circuit (220) comprising an analog dynamic range compression circuit (222), wherein said analog dynamic range compression circuit (222) is a non-linear amplification circuit having a symmetrical transfer function, said transfer function being, for positive input signals, an increasing monotonous function having its derivative monotonously decreasing according to the amplitude of the input signal, so that the analog dynamic range compression circuit (222) more strongly amplifies signals having a relatively small amplitude in absolute value and more lightly amplifies signals having a relatively high amplitude in absolute value.

**2.** Circuit (103) according to claim 1, wherein the receive circuit (220) further comprises an analog-to-digital converter (123), the analog dynamic range compression circuit having an input node coupled to the input terminal of the receive circuit (220) and an output node coupled to an input node of the analog-to-digital converter.

**3.** Circuit (103) according to claim 2, further comprising, at the output of the analog-to-digital converter (123), a digital correction circuit (224) configured to apply to the output signal of the analog-to-digital converter (123) a digital gain variable according to the amplitude of the signal, compensating for the analog gain variation applied by the analog dynamic range compression circuit (222).

**4.** Circuit (103) according to any of claims 1 to 3, wherein the dynamic range compression circuit (222) has a transfer function of hyperbolic arcsine, arc tangent, log, or sine type.

**5.** Circuit (103) according to any of claims 1 to 3, wherein the dynamic range compression circuit (222) comprises a plurality of analog amplifiers (A1, ... AN) and an adder of analog voltages (501; 601).

**6.** Circuit (103) according to claim 5, wherein the analog amplifiers (A1, ... AN) are coupled in series, each analog amplifier (Ai) having an output node coupled to a corresponding input node (ei) of the voltage adder (501).

**7.** Circuit (103) according to claim 6, wherein each analog amplifier (Ai) has its output node coupled to the corresponding input node (ei) of the voltage adder (501) via a switch (Ki).

**8.** Circuit (103) according to claim 6 or 7, wherein the analog amplifiers (A1, ... AN) are linear amplifiers and all have substantially the same gain.

**9.** Circuit (103) according to claim 5, wherein the analog amplifiers (A1, ... AN) are connected by their respective input nodes, each analog amplifier (Ai) having an output node coupled to a corresponding input node (ei) of the voltage adder (601).

**10.** Circuit (103) according to claim 9, wherein each analog amplifier (Ai) has its output node coupled to the corresponding input node (ei) of the voltage adder (601) via a switch (Ki).

**11.** Circuit (103) according to claim 10, wherein the analog amplifiers (A1, ... AN) are linear amplifiers and all have different gains.

Fig 1

Fig 2

Fig 3

Fig 4

Fig 5

Fig 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2004714

- WO 9701768 A2